# EUROPEAN PATENT SPECIFICATION

(11) **EP 3 723 118 B1**
(45) Date of publication and mention of the grant of the patent: **03.11.2021**
(21) Application number: 18901559.7
(22) Date of filing: 21.12.2018
(51) Int. Cl.: H01L 21/67, H01L 51/42, C23C 14/12, H01L 51/00

(54) **APPARATUS FOR IMMERSION-BASED PREPARATION OF PEROVSKITE THIN FILM, USE METHOD AND APPLICATION THEREOF**
VORRICHTUNG ZUR TAUCHBASIERTEN HERSTELLUNG EINES PEROWSKIT-DÜNNFILMS, VERWENDUNGSVERFAHREN UND ANWENDUNG DAVON
APPAREIL POUR LA PRÉPARATION À BASE D'IMMERSION DE FILM MINCE DE PÉROVSKITE, SON PROCÉDÉ D'UTILISATION ET SON APPLICATION

(30) Priority: 17.01.2018 CN 201810046196
(43) Date of publication of application: 14.10.2020
(73) Proprietor: Hangzhou Microquanta Semiconductor Corporation Limited, Hangzhou, Zhejiang 311121 (CN)
(72) Inventor: YAO, Jizhong, Hangzhou, Zhejiang 311121 (CN); YAN, Buyi, Hangzhou, Zhejiang 311121 (CN); SHENG, Rui, Hangzhou, Zhejiang 311121 (CN); GU, Nannan, Hangzhou, Zhejiang 311121 (CN)
(74) Representative: Sun, Yiming
(86) International application number: PCT/CN2018/122633
(87) International publication number: WO 2019/141045

(56) References cited:
- WO-A1-2016/081789
- CN-A- 104 183 697
- CN-A- 104 393 109
- CN-A- 104 393 109
- CN-A- 106 282 922
- CN-A- 106 917 064
- CN-A- 106 917 064
- US-A1- 2017 229 647

## Description

### TECHNICAL FIELD

The invention belongs to the technical field of perovskite solar cells, and particularly relates to an apparatus for immersion-based preparation of a perovskite thin film, and a use method and application thereof.

### BACKGROUND

A solar cell is a photoelectric conversion device that converts solar energy into electrical energy by using the photovoltaic effect of semiconductors. So far, solar power generation has become the most important renewable energy source besides hydraulic power generation and wind power generation. Semiconductors currently used for commercialization include monocrystalline silicon, polycrystalline silicon, amorphous silicon, cadmium telluride, copper indium gallium selenide and the like, but most of them are high in energy consumption and high in cost.

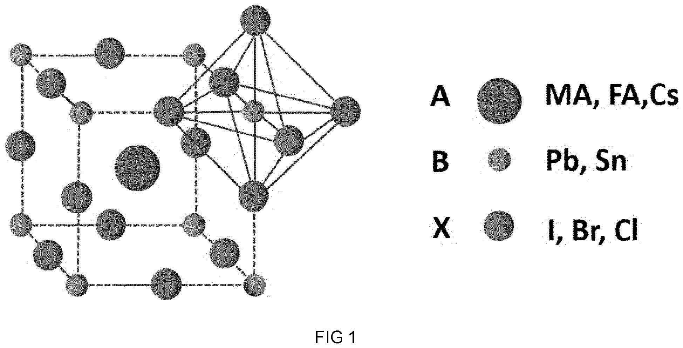

In recent years, a perovskite solar cell has drawn widespread attention. Perovskite solar cell uses organo-metal halide material as a light absorbing layer. Perovskite has an ABX₃ type cubic octahedral structure, as shown in FIG. 1. The thin film solar cell prepared by this material has the advantages of straightforward process, low production cost, high stability and high conversion rate. Since 2009, its photoelectric conversion efficiency has increased from 3.8% to above 22%, which is higher than that of commercialized crystalline silicon solar cells. Thus, the thin film solar cell has greater cost advantages.

Various existing thin film forming processes of perovskite solar cells can be divided into two categories: solution based method and vapor based method. Solution based method is easy to operate, but uniformity of the as formed thin film is poor and process repeatability is questionable, all affecting the efficiency of the solar cell. Vapor based method includes dual source co-evaporation method, vapor-assisted solution method, chemical vapor deposition (CVD) method and other methods. Among them, vapor-assisted solution method can be used for preparing uniform perovskite thin film with large grain size and small surface roughness, but process repeatability and as formed film quality need to be improved.

Document CN 106917064 A discloses a preparation method and associated apparatus, developed for growing ABX3-type perovskite thin film through single step in-situ process.

### SUMMARY

The technical problem to be solved by the present invention is to provide an apparatus for immersion-based preparation of a perovskite thin film, and a use method and application thereof. A uniform and stable reaction environment is provided in the present disclosure so that crystal growth of the thin film can be controlled in the preparation process, the as formed film quality and uniformity and process repeatability are improved, and thus, the present disclosure can be embedded into a large-scale production line for continuous production.

The present invention is realized by providing an apparatus for immersion-based preparation of a perovskite thin film, including a sealed cavity. The sealed cavity is internally provided with at least one semi-enclosed reactor device therein, the semi-enclosed reactor device includes a lower heating and sublimation device and an upper heating station, a container with an opening facing upward is provided at the top of the lower heating and sublimation device, the container contains a reactant precursor, a substrate frame is provided directly above the container, the substrate frame covers an opening of the container, a substrate frame support platform is provided at a side surface of the container, the substrate frame is disposed on the substrate frame support platform, a substrate to be deposited is provided at a lower bottom surface of the substrate frame, the substrate is located directly above the container, a surface to be deposited of the substrate directly faces the reactant precursor in the container, the upper heating station is disposed on the substrate frame to heat the substrate, and the reactant precursor is evaporated and deposited onto the surface of the substrate; and a vacuum pressure in the sealed cavity is controlled, and heating temperatures of the upper heating station and the lower heating and sublimation device are controlled.

Further, an area of the opening of the container is greater than an area of the substrate. Further, the substrate frame may drive the substrate to reciprocate back and forth in a horizontal or vertical direction.

Further, a thickness of the reactant precursor in the container is 2-10 mm with a thickness difference not exceeding 0.1-1.0 mm; and a height distance between the surface to be deposited of the substrate and a top surface of the reactant precursor is 5-40 mm.

Further, a vacuum pressure range in the sealed cavity is 10⁻⁵Pa-10⁵Pa, a heating temperature range of the upper heating station is 20-400°C, a heating temperature range of the lower heating and sublimation device is 20-400°C, and a reaction time is 10-120 min.

Further, the sealed cavity is a small-scale cavity or a large-scale continuous production apparatus, and the vacuum pressure in the sealed cavity is controlled by a vacuum pump and a vacuum valve.

The present invention is realized by further providing a use method of the apparatus for immersion-based preparation of a perovskite thin film as described above, including the following steps:
at step 1, pouring a reactant precursor material into a container, disposing a substrate on an inner bottom surface of a substrate frame with a surface to be deposited of the substrate facing downward, placing the substrate frame on a substrate frame support platform, and then putting a well-set semi-enclosed reactor device into a sealed cavity;
at step 2, extracting air in the sealed cavity to control a vacuum pressure in the sealed cavity; respectively energizing an upper heating station and a lower heating and sublimation device to control heating temperatures of the upper heating station and the lower heating and sublimation device such that the reactant precursor is evaporated and deposited onto the surface of the substrate; and
at step 3, after continuing the reaction for 10-120 min, deenergizing the upper heating station and the lower heating and sublimation device to stop heating, restoring the sealed cavity to an atmospheric pressure, and taking out the substrate deposited with the reactant precursor.

Further, at step 1, a thickness of the reactant precursor in the container is 2-10 mm with a thickness difference not exceeding 0.1-1.0 mm, and a height distance between the surface to be deposited of the substrate and a top surface of the reactant precursor is 5-40 mm.

Further, at step 2, the substrate frame may drive the substrate to reciprocate back and forth in a horizontal or vertical direction.

Further, at step 2, the sealed cavity is a small-scale cavity or a large-scale continuous production apparatus, and the vacuum pressure in the sealed cavity is controlled by a vacuum pump and a vacuum valve.

Further, at step 2, a vacuum pressure range in the sealed cavity is 10⁻⁵Pa-10⁵Pa, a heating temperature range of the upper heating station is 20-400°C, and a heating temperature range of the lower heating and sublimation device is 20-400°C.

The present invention is realized by further providing a perovskite solar cell, wherein the perovskite solar cell includes a perovskite layer, and the apparatus for immersion-based preparation of a perovskite thin film as described above is used in a preparation process of the perovskite layer.

The present invention is realized by further providing a preparation method of the perovskite solar cell as described above, wherein the perovskite solar cell includes a first conductive electrode, a first transport layer, a perovskite thin film layer, a second transport layer and a second conductive electrode. The preparation method including the following steps S1-S6:
at step S1, preparing the first transport layer on the first conductive electrode;
at step S2, depositing one or more metal halide BX₂ thin films on a substrate deposited with the first transport layer by any processing method of spin coating, blade coating, slot die continuous coating, spray coating, printing or vacuum deposition;
at step S3, fixing the substrate deposited with the metal halide BX₂ thin film, as a substrate to be deposited, to a substrate frame of the apparatus for immersion-based preparation of a perovskite thin film as described above, placing one or more reactants AX in a container and flattening each reactant AX uniformly with the surface to be deposited of the substrate directly facing the reactant AX in the container, heating an upper heating station and a lower heating and sublimation device at the same time, controlling an vacuum pressure in the sealed cavity, and controlling heating temperatures of the upper heating station and the lower heating and sublimation device such that the reactant AX is evaporated and deposited onto the surface of the substrate containing the metal halide BX₂ to produce the perovskite thin film layer;
at step S4, after the reaction is finished, taking out the deposited substrate;
at step S5, depositing the second transport layer on the prepared perovskite thin film layer; and
at step S6, depositing the second conductive electrode.

In the metal halide BX₂, B is any one of divalent metal cations: lead, tin, tungsten, copper, zinc, gallium, germanium, arsenic, selenium, rhodium, palladium, silver, cadmium, indium, antimony, osmium, iridium, platinum, gold, mercury, thallium, bismuth and polonium, and X is any anion of chlorine, bromine, iodine, thiocyanate, cyanide and oxycyanide; a thickness of the metal halide BX₂ thin film is 80-300 nm.

In the reactant AX, A is any cation of cesium, rubidium, potassium, amino, amidino or alkali group, and X is any anion of chlorine, bromine, iodine, thiocyanate, cyanide and oxycyanide.

Further, a thickness of the reactant precursor in the container is 2-10 mm, a thickness difference of each reactant precursor does not exceed 0.1-1.0 mm, and a height distance between the surface to be deposited of the substrate and a top surface of the reactant precursor is 5-40 mm; and a vacuum pressure range in the sealed cavity is 10⁻⁵Pa-10⁵Pa, a heating temperature range of the upper heating station is 100-400°C, a heating temperature range of the lower heating and sublimation device is 100-400°C, and a thickness of the prepared perovskite thin film layer is 100-600 nm.

Further, the substrate frame may drive the substrate to reciprocate back and forth in a horizontal or vertical direction.

Further, the sealed cavity is a small-scale cavity or a large-scale continuous production apparatus, and the vacuum pressure in the sealed cavity is controlled by a vacuum pump and a vacuum valve.

Compared with the prior art, the apparatus for immersion-based preparation of a perovskite thin film, and a use method and application thereof of the present invention provide a uniform and stable reaction environment, so that crystal growth of the thin film can be controlled in the preparation process of the perovskite thin film, the film formation quality, and uniformity and repeatability are improved, and thus the present invention can be embedded into a large-scale production line for continuous production.

Compared with the prior art, the present invention also has the following characteristics:
1. The quality of the perovskite thin film to be formed can be accurately controlled, and the uniformity of the perovskite thin film is improved.
2. A complete reaction of the metal halide and the halide vapor is promoted, and the controllability of perovskite crystallization is improved.
3. A solution capable of realizing continuous production is provided.
4. The deposition rate and the material utilization ratio are improved.
5. The deposition under vacuum prevents the perovskite material against decomposition or deterioration.

### BRIEF DESCRIPTION OF THE DRAWINGS

FIG. 1 is a schematic diagram of a molecular structure of a perovskite thin film in the prior art.
FIG. 2 is a schematic plan view of a preferred embodiment of an apparatus for immersion-based preparation of a perovskite thin film of the present invention.
FIG. 3 is a schematic plan view of a preferred embodiment of a semi-enclosed device in FIG. 2.
FIG. 4 is a schematic diagram of a preferred embodiment of a substrate frame in FIG. 3.
FIG. 5 is a preparation flow chart of a perovskite thin film in a perovskite solar cell of the present invention.
FIG. 6 is a scanning electron micrograph of a perovskite thin film prepared by using the apparatus for immersion-based preparation of a perovskite thin film of the present invention.
FIG. 7 is a JV curve of the perovskite solar cell prepared by using the apparatus for immersion-based preparation of a perovskite thin film of the present invention.

### DETAILED DESCRIPTION OF THE EMBODIMENTS

In order to make the technical problems to be solved, technical solutions and advantageous effects of the invention clearer, the present invention will be described in detail below with reference to the accompanying drawing and embodiments. It should be understood that the specific embodiments described herein are merely illustrative of the present invention and are not intended to limit the invention.

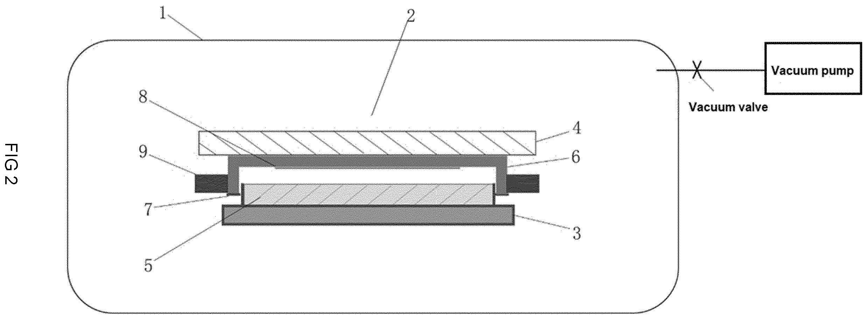

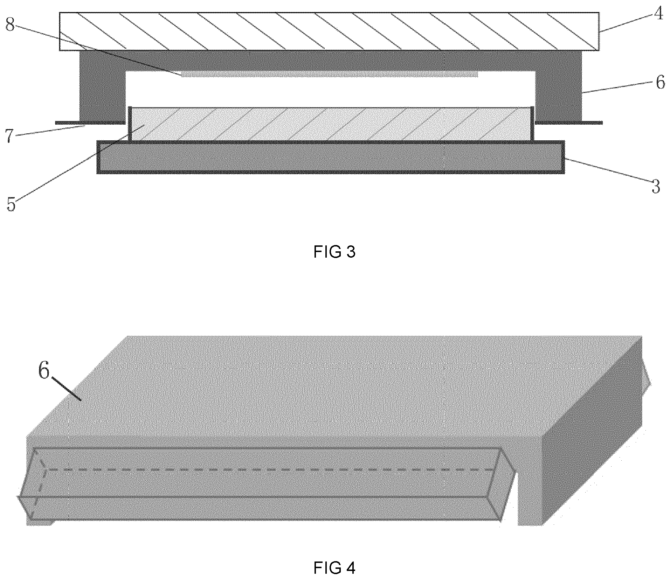

With reference to FIG. 2, FIG. 3 and FIG. 4 at the same time, an apparatus for immersion-based preparation of a perovskite thin film according to the present invention includes a sealed cavity 1, wherein the sealed cavity 1 is internally provided with at least one semi-enclosed reactor device 2.

The semi-enclosed reactor device 2 includes a lower heating and sublimation device 3 and an upper heating station 4. A container 5 with an opening facing upward is provided at the top of the lower heating and sublimation device 3. The container 5 contains a reactant precursor. A substrate frame 6 is provided directly above the container 5. The substrate frame 6 covers an opening of the container 5. A substrate frame support platform 7 is provided at a side surface of the container 5. The substrate frame 6 is disposed on the substrate frame support platform 7. A substrate 8 to be deposited is provided at a lower bottom surface of the substrate frame 6, the substrate 8 is located directly above the container 5, and a surface to be deposited of the substrate 8 directly faces the reactant precursor in the container 5. The upper heating station 4 is disposed on the substrate frame 6 to heat the substrate 8. The reactant precursor is evaporated and deposited onto the surface of the substrate 8. An vacuum pressure in the sealed cavity 1 is controlled, and heating temperatures of the upper heating station 4 and the lower heating and sublimation device 3 are controlled. The upper heating station 4 is disposed at the top of the substrate frame 6, a reactant heating device for heating the reactant precursor in the container 5 is disposed in the lower heating and sublimation device 3, and a substrate heating device for heating the substrate 8 is disposed on the upper heating station 4.

An area of the opening of the container 5 is greater than an area of the substrate 8. A thickness of the reactant precursor in the container 5 is 2-10 mm, with a thickness difference not exceeding 0.1-1.0 mm. A height distance between the surface to be deposited of the substrate 8 and a top surface of the reactant precursor is 5-40 mm.

A vacuum pressure range in the sealed cavity 1 is 10⁻⁵Pa-10⁵Pa, a heating temperature range of the upper heating station 4 is 20-400°C, a heating temperature range of the lower heating and sublimation device 3 is 20-400°C, and a reaction time is 10-120 min.

The apparatus for immersion-based preparation of a perovskite thin film of the present invention further includes a transmission device 9, wherein the transmission gear 9 drives the substrate frame support platform 7 such that the substrate frame 6 reciprocate back and forth in a horizontal direction or vertical direction.

The sealed cavity 1 of the present invention is a small-scale cavity or a large-scale continuous production apparatus. The vacuum pressure in the sealed cavity 1 is controlled by a vacuum pump and a vacuum valve.

The invention further discloses a use method of the apparatus for immersion-based preparation of a perovskite thin film as described above, and the method includes the following steps1-3.

At step 1, a reactant precursor material is poured into a container 5, a substrate 8 is disposed on an inner bottom surface of a substrate frame 6 with a surface to be deposited of the substrate facing downward, the substrate frame 6 is disposed on a substrate frame support platform 7, and then a well-set semi-enclosed reactor device 2 is put into a sealed cavity 1.

At step 2, air in the sealed cavity 1 is extracted to control an vacuum pressure in the sealed cavity 1, and an upper heating station 4 and a lower heating and sublimation device 3 are respectively energized to control heating temperatures of the upper heating station 4 and the lower heating and sublimation device 3 such that the reactant precursor is evaporated and deposited onto the surface of the substrate 8.

At step 3,, after the reaction is continued for 10-120 min, the upper heating station 4 and the lower heating and sublimation device 3 are de-energized to stop heating an atmospheric pressure is restored in the sealed cavity 1, and the substrate 8 deposited with the reactant precursor is taken out.

At step 1, a thickness of the reactant precursor in the container 5 is 2-10 mm with a thickness difference not exceeding 0.1-1.0 mm, and a height distance between the surface to be deposited of the substrate 8 and a top surface of the reactant precursor is 5-40 mm.

At step 2, a vacuum pressure range in the sealed cavity 1 is 10⁻⁵Pa-10⁵Pa, a heating temperature range of the upper heating station 4 is 20-400°C, and a heating temperature range of the lower heating and sublimation device 3 is 20-400°C.

At step 2, the substrate frame 6 may drive the substrate 8 to reciprocate back and forth in a horizontal or vertical direction.

At step 2, the sealed cavity is a small-scale cavity or a large-scale continuous production apparatus, and the vacuum pressure in the sealed cavity is controlled by a vacuum pump and a vacuum valve.

The present invention further discloses a perovskite solar cell, wherein the perovskite solar cell includes a perovskite layer, and the apparatus for immersion-based preparation of a perovskite thin film as described above is used in a preparation process of the perovskite layer.

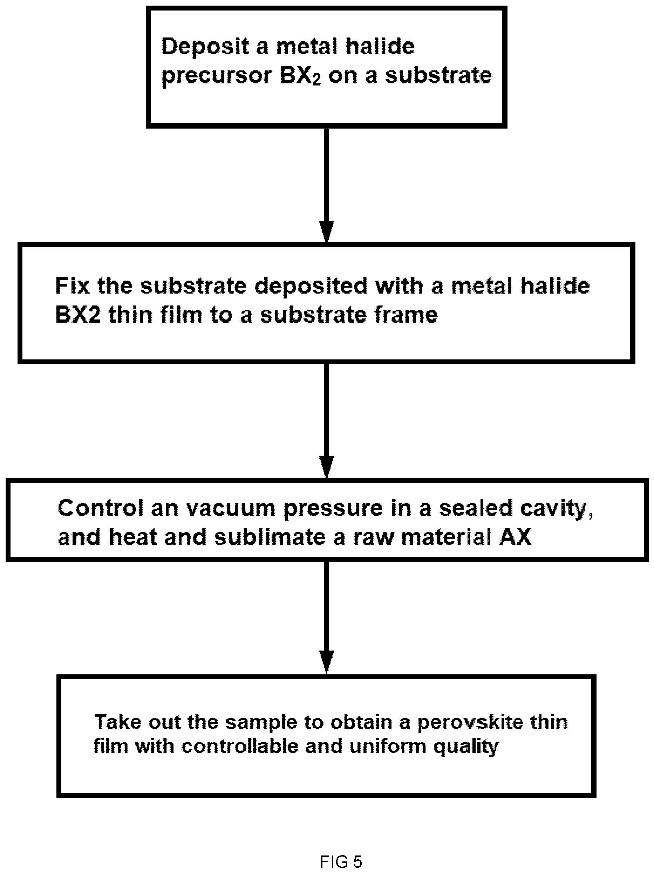

With reference to FIG. 5, the present invention further discloses a preparation method of a perovskite solar cell, wherein the perovskite solar cell includes a first conductive electrode, a first transport layer, a perovskite thin film layer, a second transport layer and a second conductive electrode. The preparation method includes the following steps S1-S6.

At step S1, the first transport layer is prepared on the first conductive electrode.

At step S2, one or more metal halide BX₂ thin films is deposited on a substrate deposited with the first transport layer by any processing method of spin coating, blade coating, slot die continuous coating, spray coating, printing or vacuum deposition.

At step S3, the substrate 8 deposited with the metal halide BX₂ thin film is fixed, as a substrate to be deposited, to a substrate frame 6 of the apparatus for immersion-based preparation of a perovskite thin film as described above, one or more reactants AX is placed in the container 5 and flattened each uniformly while the surface to be deposited of the substrate 8 faces downward the reactant AX in the container 5, the upper heating station 4 and the lower heating and sublimation device 3 are heated at the same time, the vacuum pressure in the sealed cavity 1 is controlled, and heating temperatures of the upper heating station 4 and the lower heating and sublimation device 3 are controlled such that the reactant AX is evaporated and deposited onto the surface of the substrate 8 containing the metal halide BX₂ to produce the perovskite thin film layer.

At step S4, after the reaction is finished, the deposited substrate 8 is taken out.

At step S5, the second transport layer is deposited on the perovskite thin film layer of the substrate 8.

At step S6, the second conductive electrode is deposited.

In the metal halide BX₂, B is any one of divalent metal cations: lead (Pb²⁺), tin (Sn²⁺), tungsten (W²⁺), copper (Cu²⁺), zinc (Zn²⁺), gallium (Ga²⁺), germanium (Ge²⁺), arsenic (As²⁺), selenium (Se²⁺), rhodium (Rh²⁺), palladium (Pd²⁺), silver (Ag²⁺), cadmium (Cd²⁺), indium (In²⁺), antimony (Sb²⁺), osmium (Os²⁺), iridium (Ir²⁺), platinum (Pt²⁺), gold (Au²⁺), mercury (Hg²⁺), thallium (TI²⁺), bismuth (Bi²⁺) and polonium (Po²⁺), and X is any anion of chlorine (Cl⁻), bromine (Br), iodine (I⁻), thiocyanate (NCS⁻), cyanide (CN⁻) and oxycyanide (NCO-); and a thickness of the metal halide BX₂ thin film is 80-300 nm.

In the reactant AX, A is any cation of cesium (Cs⁺), rubidium (Rb⁺), potassium (K⁺), amino, amidino or alkali group, and X is any anion of chlorine (Cl⁻), bromine (Br), iodine (I⁻), thiocyanate (NCS⁻), cyanide (CN⁻) and oxycyanide (NCO⁻).

A thickness of the reactant precursor in the container 5 is 2-10 mm with a thickness difference of each reactant precursor not exceeding 0.1-1.0 mm, and a height distance between the surface to be deposited of the substrate 8 and a top surface of the reactant precursor is 5-40 mm. A vacuum pressure range in the sealed cavity 1 is 10⁻⁵Pa-10⁵Pa, a heating temperature range of the upper heating station 4 is 100-400°C, a heating temperature range of the lower heating and sublimation device 3 is 100-400°C, and a thickness of the prepared perovskite thin film layer is 100-600 nm.

The substrate frame 6 may drive the substrate 8 to reciprocate back and forth in a horizontal or vertical direction.

The sealed cavity is a small-scale cavity or a large-scale continuous production apparatus, and the vacuum pressure in the sealed cavity 1 is controlled by a vacuum pump and a vacuum valve.

The method for preparing the perovskite solar cell by using the apparatus for immersion-based preparation of a perovskite thin film of the present invention will be described below with reference to specific embodiments.

### Embodiment 1

A preparation method of a perovskite solar cell included the following steps:
(1) a 10×10cm ITO glass plate was subjected to ultrasonic cleaning sequentially with a detergent, deionized water, acetone and isopropanol for 30 min each, then blow-dried with N₂ and treated with UV O-zone for 10 min;
(2) a PEDOT:PSS thin film was prepared as a hole transport layer;
(3) a metal halide thin film precursor solution was prepared: 461 mg of Pbl₂ (1 mmol) was dissolved in 1 mL of DMF solution, heating and stirring were performed at 60°C for 2h, and the mixture was for later use after the dissolution;
(4) a doped Pbl₂ thin film was prepared by using the prepared precursor solution by slot die coating;
(5) a substrate 8 deposited with a metal halide thin film was fixed to a substrate frame 6 with a surface to be deposited facing downward, a reaction cavity upper cover was transmitted by a transmission device to be directly above an evaporating dish fully covered with MAI such that the reaction cavity upper cover was disposed above the substrate frame support platform 7, vacuumizing was performed by a vacuum pump to control the vacuum pressure, a feedback was given to the vacuum valve to close the vacuum valve after the gas pressure reached a certain value, an vacuum pressure range in a cavity body of a sealed cavity 1 was 10⁻⁵Pa-10⁵Pa, a heating temperature of a lower heating and sublimation device 3 was controlled at 100°C-200°C, and a heating temperature of an upper heating station 4 was controlled at 100°C-200°C such that MAI gas molecules reacted with Pbl₂ to produce a perovskite thin film, wherein a reaction time was 10-120 min;
(6) an electron transport layer PCBM was deposited; and
(7) a metal conductive layer Ag electrode was evaporated to obtain the perovskite solar cell.

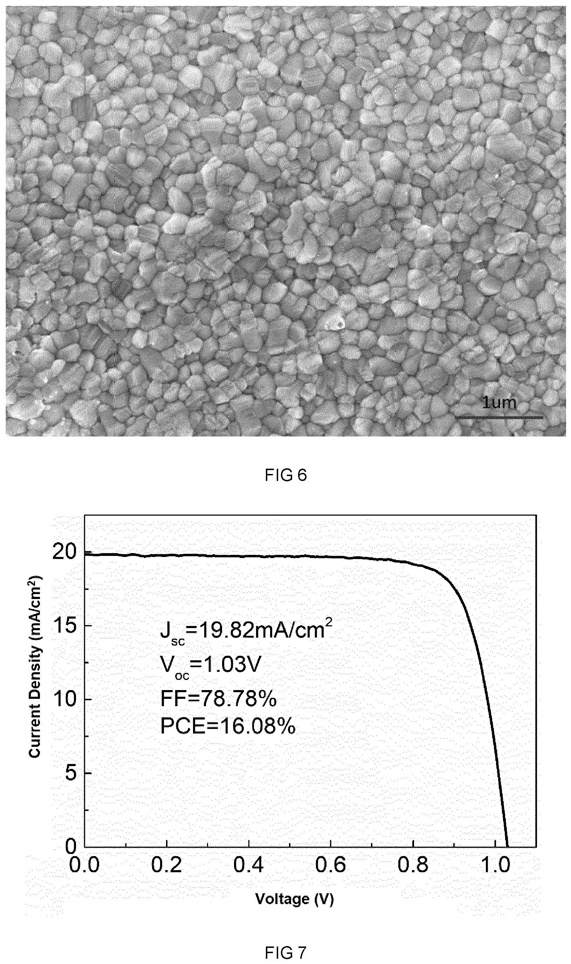

FIG. 6 is a scanning electron micrograph of a perovskite thin film prepared by using an apparatus for immersion-based preparation of a perovskite thin film of the present invention. It can be seen from the figure that the perovskite prepared by this method is smooth and dense and has uniform crystal particle size.

FIG. 7 is a JV curve of a perovskite solar cell prepared by using an apparatus for immersion-based preparation of a perovskite thin film of the present invention. A cell efficiency reaches 16.08% (PCE).

The invention is defined by the appended claims.

## Claims

1. An apparatus for immersion-based preparation of a perovskite thin film, comprising a sealed cavity (1), wherein the sealed cavity is internally provided with at least one semi-enclosed reactor device (2), the semi-enclosed reactor device comprises a lower heating and sublimation device (3) and an upper heating station (4), a container (5) with an opening facing upward is provided at the top of the lower heating and sublimation device, the container contains a reactant precursor, a substrate frame (6) is provided directly above the container the substrate frame covers an opening of the container, a substrate frame support platform (7) is provided at a side surface of the container, the substrate frame is disposed on the substrate frame support platform, a substrate (8) to be deposited is provided at a lower bottom surface of the substrate frame, the substrate is located directly above the container, one surface of the substrate to be deposited of directly faces the reactant precursor in the container, the upper heating station is disposed on the substrate frame to heat the substrate, and the reactant precursor is evaporated and deposited onto the surface of the substrate; and an vacuum pressure in the sealed cavity is controlled, and heating temperatures of the upper heating station and the lower heating and sublimation device are controlled.

2. The apparatus according to claim 1, wherein an area of the opening of the container is greater than an area of the substrate.

3. The apparatus according to claim 1, wherein the substrate frame is capable of driving the substrate to reciprocate back and forth in a horizontal or vertical direction.

4. The apparatus according to claim 1, wherein a thickness of the reactant precursor in the container is 2-10 mm, with a thickness difference not exceeding 0.1-1.0 mm; and a height distance between the surface to be deposited of the substrate and a top surface of the reactant precursor is 5-40 mm.

5. The apparatus according to claim 1, wherein a vacuum pressure range in the sealed cavity is 10⁻⁵Pa-10⁵Pa, a heating temperature range of the upper heating station is 20-400°C, a heating temperature range of the lower heating and sublimation device is 20-400°C, and a reaction time is 10-120 min.

6. The apparatus according to claim 1, wherein the sealed cavity is a small-scale cavity or a large-scale continuous production apparatus, and the vacuum pressure in the sealed cavity is controlled by a vacuum pump and a vacuum valve.

7. A use method of the apparatus for immersion-based preparation of a perovskite thin film according to claim 1, comprising the following steps:
at step 1, pouring a reactant precursor material into a container (5), disposing a substrate (8) on an inner bottom surface of a substrate frame (6) with a surface to be deposited facing downward, placing the substrate frame on a substrate frame support platform (7), and then putting a well-set semi-enclosed reactor device (2) into a sealed cavity (1);
at step 2, extracting air in the sealed cavity to control an vacuum pressure in the sealed cavity; respectively energizing an upper heating station (4) and a lower heating and sublimation device (3), and controlling heating temperatures of the upper heating station and the lower heating and sublimation device such that a reactant precursor is evaporated and deposited onto the surface of the substrate; and
at step 3, after continuing the reaction for 10-120 min, de-energizing the upper heating station and the lower heating and sublimation device to stop heating restoring the sealed cavity to an atmospheric pressure, and taking out the substrate deposited with the reactant precursor.

8. The use method according to claim 7, wherein at step1, a thickness of the reactant precursor in the container is 2-10 mm with a thickness difference not exceeding 0.1-1.0 mm, and a height distance between the surface to be deposited of the substrate and a top surface of the reactant precursor is 5-40 mm.

9. The use method according to claim 7, wherein at step 2, the substrate frame is capable of driving the substrate to reciprocate back and forth in a horizontal or vertical direction.

10. The use method according to claim 7, wherein at step 2, the sealed cavity is a small-scale cavity or a large-scale continuous production apparatus, and the vacuum pressure in the sealed cavity is controlled by a vacuum pump and a vacuum valve.

11. The use method according to claim 7, wherein at step 2, a vacuum pressure range in the sealed cavity is 10⁻⁵Pa-10⁵Pa, a heating temperature range of the upper heating station is 20-400°C, and a heating temperature range of the lower heating and sublimation device is 20-400°C.

12. A perovskite solar cell, comprising a perovskite layer, wherein the apparatus for immersion-based preparation of a perovskite thin film according to claim 1 is used in a preparation process of the perovskite layer.

13. A preparation method of the perovskite solar cell according to claim 12, wherein the perovskite solar cell comprises a first conductive electrode, a first transport layer, a perovskite thin film layer, a second transport layer and a second conductive electrode, and the preparation method comprises the following steps:
at step S1, preparing the first transport layer on the first conductive electrode;
at step S2, depositing one or more metal halide BX₂ thin films on a substrate (8) deposited with the first transport layer by any processing method of spin coating, blade coating, slot die continuous coating, spray coating, printing or vacuum deposition;
at step S3, fixing the substrate deposited with the metal halide BX₂ thin film, as a substrate to be deposited, to a substrate frame (6) of the apparatus for immersion-based preparation of a perovskite thin film according to claim 1, placing one or more reactants AX in a container (5) and flattening each reactant AX uniformly while the surface to be deposited of the substrate faces downward the reactant AX in the container, heating an upper heating station (4) and a lower heating and sublimation device (3) at the same time, controlling the vacuum pressure in a sealed cavity (1), and controlling heating temperatures of the upper heating station and the lower heating and sublimation device such that the reactant AX is evaporated and deposited onto the surface of the substrate containing the metal halide BX₂ to produce the perovskite thin film layer;
at step S4, after the reaction is finished, taking out the deposited substrate;
at step S5, depositing the second transport layer on the perovskite thin film layer; and
at step S6, depositing the second conductive electrode;
wherein in the metal halide BX₂, B is any one of divalent metal cations: lead, tin, tungsten, copper, zinc, gallium, germanium, arsenic, selenium, rhodium, palladium, silver, cadmium, indium, antimony, osmium, iridium, platinum, gold, mercury, thallium, bismuth and polonium, and X is any anion of chlorine, bromine, iodine, thiocyanate, cyanide and oxycyanide; a thickness of the metal halide BX₂ thin film is 80-300 nm; and
in the reactant AX, A is any cation of cesium, rubidium, potassium, amino, amidino or alkali group, and X is any anion of chlorine, bromine, iodine, thiocyanate, cyanide and oxycyanide.

14. The preparation method according to claim 13, wherein a thickness of the reactant precursor in the container is 2-10 mm, a thickness difference of each reactant precursor does not exceed 0.1-1.0 mm, and a height distance between the surface to be deposited of the substrate and a top surface of the reactant precursor is 5-40 mm; and a vacuum pressure range in the sealed cavity is 10⁻⁵Pa-10⁵Pa, a heating temperature range of the upper heating station is 100-400°C, a heating temperature range of the lower heating and sublimation device is 100-400°C, and a thickness of the prepared perovskite thin film layer is 100-600 nm.

15. The preparation method according to claim 13, wherein the substrate frame is capable of driving the substrate to reciprocate back and forth in a horizontal or vertical direction.

16. The preparation method according to claim 13, wherein the sealed cavity is a small-scale cavity or a large-scale continuous production apparatus, and the vacuum pressure in the sealed cavity is controlled by a vacuum pump and a vacuum valve.

## Patentansprüche

1. Vorrichtung zur immersionsbasierten Herstellung eines Perowskit-Dünnfilms, umfassend einen abgedichteten Hohlraum (1), wobei der abgedichtete Hohlraum intern mit mindestens einer halbgeschlossenen Reaktoreinrichtung (2) vorgesehen ist, wobei die halbgeschlossene Reaktoreinrichtung eine untere Heiz- und Sublimationseinrichtung (3) und eine obere Heizstation (4) umfasst, wobei ein Behälter (5) mit einer nach oben gewandten Öffnung an dem Oberteil der unteren Heiz- und Sublimationseinrichtung vorgesehen ist, wobei der Behälter einen Vorläufer-Reaktant beinhaltet, wobei ein Substratrahmen (6) direkt über dem Behälter vorgesehen ist, wobei der Substratrahmen eine Öffnung des Behälters abdeckt, wobei eine Substratrahmen-Trägerplattform (7) an einer Seitenfläche des Behälters vorgesehen ist, wobei der Substratrahmen auf der Substratrahmen-Trägerplattform angeordnet ist, wobei ein Abscheidungszielsubstrat (8) an einer unteren Bodenfläche des Substratrahmens vorgesehen ist, wobei sich das Substrat direkt über dem Behälter befindet, wobei eine Fläche des Abscheidungszielsubstrats dem Vorläufer-Reaktant in dem Behälter direkt zugewandt ist, wobei die obere Heizstation auf dem Substratrahmen angeordnet ist, um das Substrat zu erhitzen, und wobei der Vorläufer-Reaktant verdampft und auf der Fläche des Substrats abgeschieden wird; und wobei ein Vakuumdruck in dem abgedichteten Hohlraum gesteuert wird, und wobei Heiztemperaturen der oberen Heizstation und der unteren Heiz- und Sublimationseinrichtung gesteuert werden.

2. Vorrichtung nach Anspruch 1, wobei ein Bereich der Öffnung des Behälters größer ist als ein Bereich des Substrats.

3. Vorrichtung nach Anspruch 1, wobei der Substratrahmen in der Lage ist, das Substrat so anzutreiben, dass es sich in einer horizontalen oder vertikalen Richtung vor- und zurückbewegt.

4. Vorrichtung nach Anspruch 1, wobei eine Dicke des Vorläufer-Reaktants in dem Behälter 2-10 mm beträgt, wobei eine Dickendifferenz 0,1-1,0 mm nicht überschreitet; und wobei ein Höhenabstand zwischen der Abscheidungszielfläche des Substrats und einer Deckfläche des Vorläufer-Reaktants 5-40 mm beträgt.

5. Vorrichtung nach Anspruch 1, wobei ein Vakuumdruckbereich in dem abgedichteten Hohlraum 10⁻⁵Pa-10⁵Pa beträgt, wobei ein Heiztemperaturbereich der oberen Heizstation 20-400°C beträgt, wobei ein Heiztemperaturbereich der unteren Heiz- und Sublimationseinrichtung 20-400°C beträgt und wobei eine Reaktionszeit 10-120 min beträgt.

6. Vorrichtung nach Anspruch 1, wobei der abgedichtete Hohlraum ein kleiner Hohlraum oder eine große Vorrichtung zur kontinuierlichen Herstellung ist, und wobei der Vakuumdruck in dem abgedichteten Hohlraum durch eine Vakuumpumpe und ein Vakuumventil gesteuert wird.

7. Verfahren zur Verwendung der Vorrichtung zur immersionsbasierten Herstellung eines Perowskit-Dünnfilms nach Anspruch 1, umfassend die folgenden Schritte:
in Schritt 1: Gießen eines Vorläufer-Reaktantmaterials in einen Behälter (5), Anordnen eines Substrats (8) auf einer inneren Bodenfläche eines Substratrahmens (6) mit einer nach unten gewandten Abscheidungszielfläche, Platzieren des Substratrahmens auf einer Substratrahmen-Trägerplattform (7) und anschließend Legen einer gut eingestellten halbgeschlossenen Reaktoreinrichtung (2) in einen abgedichteten Hohlraum (1);
in Schritt 2: Absaugen von Luft in dem abgedichteten Hohlraum, um einen Vakuumdruck in dem abgedichteten Hohlraum zu steuern, jeweiliges Einschalten einer oberen Heizstation (4) und einer unteren Heiz- und Sublimationseinrichtung (3) sowie Steuern von Heiztemperaturen der oberen Heizstation und der unteren Heiz- und Sublimationseinrichtung, sodass ein Vorläufer-Reaktant verdampft und auf der Fläche des Substrats abgeschieden wird; und
in Schritt 3: nach einem Fortführen der Reaktion für 10-120 min, Ausschalten der oberen Heizstation und der unteren Heiz- und Sublimationseinrichtung, um ein Heizen zu stoppen, Wiederherstellen eines Atmosphärendrucks in dem abgedichteten Hohlraum und Herausnehmen des Substrats, auf dem der Vorläufer-Reaktant abgeschieden wurde.

8. Verwendungsverfahren nach Anspruch 7, wobei in Schritt 1 eine Dicke des Vorläufer-Reaktants in dem Behälter 2-10 mm beträgt, wobei eine Dickendifferenz 0,1-1,0 mm nicht überschreitet, und wobei ein Höhenabstand zwischen der Abscheidungszielfläche des Substrats und einer Deckfläche des Vorläufer-Reaktants 5-40 mm beträgt.

9. Verwendungsverfahren nach Anspruch 7, wobei in Schritt 2 der Substratrahmen in der Lage ist, das Substrat so anzutreiben, dass es sich in einer horizontalen oder vertikalen Richtung vor- und zurückbewegt.

10. Verwendungsverfahren nach Anspruch 7, wobei in Schritt 2 der abgedichtete Hohlraum ein kleiner Hohlraum oder eine große Vorrichtung zur kontinuierlichen Herstellung ist, und wobei der Vakuumdruck in dem abgedichteten Hohlraum durch eine Vakuumpumpe und ein Vakuumventil gesteuert wird.

11. Verwendungsverfahren nach Anspruch 7, wobei in Schritt 2 ein Vakuumdruckbereich in dem abgedichteten Hohlraum 10⁻⁵Pa-10⁵Pa beträgt, wobei ein Heiztemperaturbereich der oberen Heizstation 20-400°C beträgt und wobei ein Heiztemperaturbereich der unteren Heiz- und Sublimationseinrichtung 20-400°C beträgt.

12. Perowskit-Solarzelle, umfassend eine Perowskit-Schicht, wobei die Vorrichtung zur immersionsbasierten Herstellung eines Perowskit-Dünnfilms nach Anspruch 1 in einem Herstellungsvorgang der Perowskit-Schicht verwendet wird.

13. Verfahren zur Herstellung der Perowskit-Solarzelle nach Anspruch 12, wobei die Perowskit-Solarzelle eine erste leitende Elektrode, eine erste Transportschicht, eine Perowskit-Dünnfilmschicht, eine zweite Transportschicht und eine zweite leitende Elektrode umfasst, und wobei das Herstellungsverfahren die folgenden Schritte umfasst:
in Schritt S1: Herstellen der ersten Transportschicht auf der ersten leitenden Elektrode;
in Schritt S2: Abscheiden eines oder mehrerer Metallhalogenid-BX₂-Dünnfilme auf einem Substrat (8), auf dem die erste Transportschicht abgeschieden wurde, durch ein beliebiges Verarbeitungsverfahren wie Rotationsbeschichtung, Blattbeschichtung, kontinuierliche Schlitzdüsen-Beschichtung, Sprühbeschichtung, Druck- oder Vakuumabscheidung;
in Schritt S3: Fixieren des Substrats, auf dem der Metallhalogenid-BX₂-Dünnfilm abgeschieden wurde, als Abscheidungszielsubstrat an einem Substratrahmen (6) der Vorrichtung zur immersionsbasierten Herstellung eines Perowskit-Dünnfilms nach Anspruch 1, Platzieren eines oder mehrerer Reaktanten AX in einem Behälter (5) und gleichmäßiges Ebnen jedes Reaktants AX, während die Abscheidungszielfläche des Substrats nach unten zu dem Reaktant AX in dem Behälter gewandt ist, gleichzeitiges Erhitzen einer oberen Heizstation (4) und einer unteren Heiz- und Sublimationseinrichtung (3), Steuern des Vakuumdrucks in dem abgedichteten Hohlraum (1) und Steuern der Heiztemperaturen der oberen Heizstation und der unteren Heiz- und Sublimationseinrichtung, sodass der Reaktant AX verdampft und auf der Fläche des Substrats, welches das Metallhalogenid BX₂ enthält, abgeschieden wird, um die Perowskit-Dünnfilmschicht herzustellen;
in Schritt S4: nachdem die Reaktion abgeschlossen ist, Herausnehmen des abgeschiedenen Substrats;
in Schritt S5: Abscheiden der zweiten Transportschicht auf der Perowskit-Dünnfilmschicht; und
in Schritt S6: Abscheiden der zweiten leitenden Elektrode;
wobei in dem Metallhalogenid BX₂ B ein beliebiges zweiwertiges Metallkation von Blei, Zinn, Wolfram, Kupfer, Zink, Gallium, Germanium, Arsen, Selen, Rhodium, Palladium, Silber, Cadmium, Indium, Antimon, Osmium, Iridium, Platin, Gold, Quecksilber, Thallium, Wismut und Polonium ist und X ein beliebiges Anion von Chlor, Brom, Jod, Thiocyanat, Cyanid und Oxycyanid ist; wobei eine Dicke des Metallhalogenid-BX₂-Dünnfilms 80-300 nm beträgt; und
wobei in dem Reaktant AX A ein beliebiges Kation von Cäsium, Rubidium, Kalium, der Amino-, Amidino- oder Alkaligruppe ist und X ein beliebiges Anion von Chlor, Brom, Jod, Thiocyanat, Cyanid und Oxycyanid ist.

14. Herstellungsverfahren nach Anspruch 13, wobei eine Dicke des Vorläufer-Reaktants in dem Behälter 2-10 mm beträgt, wobei eine Dickendifferenz jedes Vorläufer-Reaktants 0,1-1,0 mm nicht überschreitet, und wobei ein Höhenabstand zwischen der Abscheidungszielfläche des Substrats und der Deckfläche des Vorläufer-Reaktants 5-40 mm beträgt; und wobei ein Vakuumdruckbereich in dem abgedichteten Hohlraum 10⁻⁵Pa-10⁵Pa beträgt, wobei ein Heiztemperaturbereich der oberen Heizstation 100-400°C beträgt, wobei ein Heiztemperaturbereich der unteren Heiz-und Sublimationseinrichtung 100-400°C beträgt und wobei eine Dicke der hergestellten Perowskit-Dünnfilmschicht 100-600 nm beträgt.

15. Herstellungsverfahren nach Anspruch 13, wobei der Substratrahmen in der Lage ist, das Substrat so anzutreiben, dass es sich in einer horizontalen oder vertikalen Richtung vor- und zurückbewegt.

16. Herstellungsverfahren nach Anspruch 13, wobei der abgedichtete Hohlraum ein kleiner Hohlraum oder eine große Vorrichtung zur kontinuierlichen Herstellung ist, und wobei der Vakuumdruck in dem abgedichteten Hohlraum durch eine Vakuumpumpe und ein Vakuumventil gesteuert wird.

## Revendications

1. Appareil pour préparation basée sur l'immersion d'un film mince de pérovskite, comprenant une cavité étanche (1), la cavité étanche étant pourvue à l'intérieur d'au moins un dispositif de réacteur semi-renfermé (2), le dispositif de réacteur de semi-renfermé comprenant un dispositif de chauffage et de sublimation inférieur (3) et une station de chauffage supérieure (4), un récipient (5) doté d'une ouverture tournée vers le haut étant prévu en haut du dispositif de chauffage et de sublimation inférieure, le récipient contenant un précurseur de réactant, un cadre du substrat (6) étant prévu directement au-dessus du récipient, le cadre de substrat couvrant une ouverture de récipient, une plate-forme support de cadre de substrat (7) étant prévue sur une face latérale du récipient, le cadre de substrat étant disposé sur la plate-forme support de cadre de substrat, un substrat (8) à déposer étant prévu sur une surface de fond inférieure du cadre de substrat, le substrat se trouvant directement au-dessus du récipient, une surface du substrat à déposer faisant directement face au précurseur de réactant dans le récipient, la station de chauffage supérieure étant disposée sur le cadre de substrat pour chauffer le substrat, et le précurseur de réactant étant évaporé et déposé sur la surface du substrat ; et une pression de vide dans la cavité étanche étant contrôlée, et les températures de chauffage de la station de chauffage supérieure et du dispositif de chauffage et de sublimation inférieur étant contrôlées.

2. Appareil selon la revendication 1, dans lequel une zone de l'ouverture de récipient est plus étendue qu'une superficie de substrat.

3. Appareil selon la revendication 1, dans lequel le cadre de substrat est capable d'entraîner le substrat en va-et-vient d'avant en arrière dans un sens vertical ou horizontal.

4. Appareil selon la revendication 1, dans lequel une épaisseur du précurseur de réactant dans le récipient et de 2 à 10 mm, avec une différence d'épaisseur n'excédant pas 0,1 à 1,0 mm ; et une distance en hauteur entre la surface à déposer du substrat et une surface supérieure du précurseur de réactant étant de 5 à 40 mm.

5. Appareil selon la revendication 1, dans lequel une plage de pression de vide dans la cavité étanche est de 10⁻⁵ Pa à 10⁵ Pa, une plage de température de chauffage de la station de chauffage supérieure est de 20 à 400 °C, une plage de température de chauffage du dispositif de chauffage et de sublimation inférieur est de 20 à 400 °C, et une durée de réaction est de 10 à 120 minutes.

6. Appareil selon la revendication 1, dans lequel la cavité étanche est une cavité à petite échelle ou un appareil de production continue à grande échelle, et la pression de vide dans la cavité étanche est contrôlée par une pompe à vide et une soupape à vide.

7. Procédé d'utilisation de l'appareil pour préparation basée sur l'immersion d'un film mince de pérovskite selon la revendication 1, comprenant les étapes suivantes :
dans l'étape 1, versement d'un matériau précurseur de réactant dans un récipient (5), disposition d'un substrat (8) sur une surface de fond intérieure d'un cadre du substrat (6) avec une surface à déposer tournée vers le bas, placement du cadre de substrat sur une plate-forme support de cadre de substrat (7) puis pose d'un dispositif de réacteur semi-renfermé (2) dans une cavité étanche (1) ;
dans l'étape 2, extraction d'air dans la cavité étanche pour contrôler une pression de vide dans la cavité étanche ; respectivement énergisation d'une station de chauffage supérieure (4) et d'un dispositif de chauffage et de sublimation inférieur (3), et contrôle des températures de chauffage de la station de chauffage supérieure et du dispositif de chauffage et de sublimation inférieur de manière à ce qu'un précurseur de réactant soit évaporé et déposé sur la surface du substrat ; et
dans l'étape 3, après avoir poursuivi la réaction pendant 10 à 120 minutes, désénergisation de la station de chauffage supérieure et du dispositif de chauffage de sublimation inférieur pour stopper le chauffage, remise de la cavité étanche sous pression atmosphérique, et extraction du substrat déposé avec le précurseur de réactant.

8. Procédé d'utilisation selon la revendication 7, dans lequel, dans l'étape 1, une épaisseur du précurseur de réactant dans le récipient est de 2 à 10 mm, avec une différence d'épaisseur n'excédant pas 0,1 à 1,0 mm, et une distance en hauteur entre la surface à déposer du substrat et une surface supérieure du précurseur de réactant est de 5 à 40 mm.

9. Procédé d'utilisation selon la revendication 7, dans lequel, dans l'étape 2, le cadre de substrat est capable d'entraîner le substrat en va-et-vient d'avant en arrière dans un sens horizontal ou vertical.

10. Procédé d'utilisation selon la revendication 7, dans lequel, dans l'étape 2, la cavité étanche est une cavité à petite échelle ou un appareil de production continue à grande échelle, et la pression de vide dans la cavité étanche est contrôlée par une pompe à vide et une soupape à vide.

11. Procédé d'utilisation selon la revendication 7, dans lequel, dans l'étape 2, une plage de pression de vide dans la cavité étanche est de 10⁻⁵ Pa à 10⁵ Pa, une plage de température de chauffage de la station de chauffage supérieure est de 20 à 400 °C, et une ouverture de chauffage du dispositif de chauffage et de sublimation inférieur est de 20 à 400 °C.

12. Cellule solaire en pérovskite, comprenant une couche de pérovskite, l'appareil pour préparation basée sur immersion d'un film mince de pérovskite selon la revendication 1 étant utilisé dans un processus de préparation de la couche de pérovskite.

13. Procédé de préparation de la cellule solaire en pérovskite selon la revendication 12, dans lequel la cellule solaire en pérovskite comprend au moins une première électrode conductrice, une première couche de transport, une couche de film mince de pérovskite, une seconde couche de transport et une seconde électrode conductrice, et le procédé de préparation comprend les étapes suivantes :
dans l'étape S1, préparation de la première couche de transport sur la première électrode conductrice ;
dans l'étape S2, dépôt d'un ou plusieurs films minces d'halogénure métallique BX₂ sur un substrat (8) déposé avec la première couche de transport par un procédé de traitement par revêtement par centrifugation, revêtement à la lame, revêtement continu par filière en fente, revêtement par pulvérisation, impression ou dépôt sous vide ;
dans l'étape S3, fixation du substrat déposé avec le film mince d'halogénure métallique BX₂ sous forme d'un substrat à déposer sur un cadre de substrat (6) de l'appareil pour préparation basée sur immersion d'un film mince de pérovskite selon la revendication 1, placement d'un ou plusieurs réactant AX dans un récipient (5) et aplatissement de chaque réactant AX uniformément, alors que la surface à déposer du substrat est tournée vers le bas vers le réactant AX dans le récipient, chauffage d'une station de chauffage supérieure (4) et d'un dispositif de chauffage et de sublimation inférieur (3) en même temps, contrôle de la pression de vide dans une cavité étanche (1) et contrôle des températures de chauffage de la station de chauffage supérieure et du dispositif de chauffage et de sublimation inférieur de manière à ce que le réactant AX soit évaporé et déposé sur la surface du substrat récipient contenant l'halogénure métallique BX₂ pour produire la couche de film mince de pérovskite ;
dans l'étape S4, une fois que la réaction est finie, extraction du substrat déposé ;
dans l'étape S5, dépôt de la seconde couche de transport sur la couche de film mince de pérovskite ; et
dans l'étape S6, dépôt de la seconde électrode conductrice ;
dans lequel procédé, dans l'halogénure métallique BX₂, B est l'un quelconque des cations métalliques divalents suivants : plomb, étain, tungstène, cuivre, zinc, gallium, germanium, arsenic, sélénium, radium, rhodium, palladium, argent, cadmium, indium, antimoine, osmium, iridium, platine, or, mercure, thallium, bismuth et polonium, et X est un anion quelconque de chlorure, bromure, iodure, thiocyanate, cyanure et oxycyanure ; une épaisseur du film mince d'halogénure métallique BX2 est de 80 à 300 nm ; et
dans le réactant AX, A est un cation quelconque de groupe césium, rubidium, potassium, amino, amidino ou alcali, et X est un cation quelconque de chlorure, bromure, iodure, thiocyanate, cyanure et oxycyanure.

14. Procédé de préparation selon la revendication 13, dans lequel une épaisseur du précurseur de réactant dans le récipient est de 2 à 10 mm, une différence d'épaisseur de chaque précurseur de réactant n'excède pas 0,1 à 1,0 mm, et une distance en hauteur entre la surface à déposer du substrat et une surface supérieure du précurseur de réactant est de 5 à 40 mm ; et une plage de pression de vide dans la cavité étanche est de 10⁻⁵ Pa à 10⁵ Pa, une plage de température de chauffage de la station de chauffage supérieure est de 100 à 400 °C, une plage de température de chauffage du dispositif de chauffage et de sublimation inférieur est de 100 à 400 °C, et une épaisseur de la couche de film mince de pérovskite préparée est de 100 à 600 nm.

15. Procédé de préparation selon la revendication 13, dans lequel le cadre de substrat est capable d'entraîner le substrat en va-et-vient d'avant en arrière dans un sens vertical ou horizontal.

16. Procédé de préparation selon la revendication 13, dans lequel la cavité étanche est une cavité à petite échelle ou un appareil de production continue à grande échelle, et la pression de vide dans la cavité étanche est contrôlée par une pompe à vide et une soupape à vide.
